# EUROPEAN PATENT SPECIFICATION

(11) **EP 4 381 999 B1**
(45) Date of publication and mention of the grant of the patent: **13.08.2025**
(21) Application number: 23176032.3
(22) Date of filing: 30.05.2023
(51) Int. Cl.: A47B 88/45, A47B 88/50, H05K 7/14, E05B 65/46, E05C 3/16, A47B 88/49, A47B 95/02, A47B 88/423

(54) **SLIDE RAIL MECHANISM AND SLIDE RAIL ASSEMBLY THEREOF**
GLEITSCHIENENMECHANISMUS UND GLEITSCHIENENANORDNUNG DARAUS
MÉCANISME DE RAIL COULISSANT ET SON ENSEMBLE RAIL COULISSANT

(30) Priority: 09.12.2022 TW 111147682
(43) Date of publication of application: 12.06.2024
(73) Proprietor: King Slide Works Co., Ltd., Kaohsiung City 82150 (TW); King Slide Technology Co., Ltd., 82151 Kaohsiung City (TW)
(72) Inventor: CHEN, Ken-Ching, 82150 Kaohsiung City (TW); YANG, Shun-Ho, 82150 Kaohsiung City (TW); YU, Kai-Wen, 82150 Kaohsiung City (TW); WANG, Chun-Chiang, 82150 Kaohsiung City (TW)
(74) Representative: Viering, Jentschura & Partner mbB Patent- und Rechtsanwälte

(56) References cited:
- US-A1- 2019 231 071
- US-A1- 2019 352 938
- US-A1- 2022 312 959
- US-B1- 10 443 271

## Description

### Field of the Invention

The present invention is related to a slide rail mechanism having an unlocking handle.

### Background of the Invention

Patent number WO 2021/146355A1 discloses a rotational bar for drawer slide latch operation. A drawer slide comprises an outer member (such as an outer rail) and an inner member (such as an inner rail) movable relative to each other. A release leaver is pivotally mounted to the inner member, and the release lever has a tab for being engaged with a predetermined catch of the outer member, such that the inner member is held in a position relative to the outer member. An arm is connected to an end of a rotating bar, and the arm is positioned to engage the release lever. According to such arrangement, when a user applies a force to the rotating bar, the rotating bar is configured to drive the arm to unlock the tab of the release lever from the catch of the outer member.

US patent number US 10,004,331 B2 discloses a drawer release mechanism, which comprises a handle extrusion. A side of the handle extrusion is provided with a first pin (or a second pin) which is engaged with a lever. The lever is pivotally mounted to an inner rail. When a user applies a force to the handle extrusion, the handle extrusion is configured to drive the first pin to move the lever, so as to unlock the inner rail from the outer rail.

The rotating bar and the handle extrusion respectively disclosed in the aforementioned two patents are configured to rotate when the user applies the force. However, there is no change in height when the rotating bar and the handle extrusion are rotated relative to the slide rail (or the drawer). In addition, the rotating bar is engaged with the release lever; similarly, the handle extrusion is also engaged with the lever through the first pin.

However, in order to meet diverse requirements of the market, sometimes it is not desirable to unlock the rail through the arrangement disclosed in the aforementioned patents. Therefore, it is important to develop various products.

US 10 443 271 B1 discloses a slide rail mechanism, comprising: a first slide rail assembly (203) and a second slide rail assembly, each of the first and second slide rail assemblies comprising a first rail and a second rail movable relative to each other, and a locking member configured to lock the second rail relative to the first rail at a predetermined position; and an unlocking handle movably mounted between the first slide rail assembly and the second slide rail assembly; wherein when the unlocking handle is moved from a first position to a second position, the unlocking handle is configured to drive the locking member to move in order to unlock the second rail relative to the first rail at the predetermined position; wherein the unlocking handle is configured to be linearly moved from the first position to the second position.

Further slide rail mechanisms are known from US 2019/231071 A1, US 2019/352938 A1, and US 2022/312959 A1.

### Summary of the Invention

This in mind, the present invention aims at providing a slide rail mechanism having an unlocking handle.

This is achieved by a slide rail mechanism according to claim 1. The dependent claims pertain to corresponding further developments and improvements.

### Brief Description of the Drawings

In the following, the invention is further illustrated by way of example, taking reference to the accompanying drawings thereof:
FIG. 1 is a diagram showing slide rail assemblies of a slide rail mechanism being in a retracted state with an unlocking handle being located at a first position according to a first example not according to the present invention;
FIG. 2 is an exploded view of the slide rail mechanism according to the first example not according to the present invention;
FIG. 3 is a diagram showing the slide rail mechanism with the unlocking handle being located at a second position according to the first example not according to the present invention.
FIG. 4 is a diagram showing a second rail of the slide rail assembly being locked relative to a first rail at a predetermined position with the unlocking handle being located at the first position according to the first example not according to the present invention;
FIG. 5 is a diagram showing the second rail of the slide rail assembly being locked relative to the first rail at the predetermined position with the unlocking handle being operated according to the first example not according to the present invention;
FIG. 6 is a diagram showing the unlocking handle being located at the second position to unlock the second rail relative to the first rail of the slide rail assembly according to the first example not according to the present invention;
FIG. 7 is a diagram showing the slide rail assemblies of the slide rail mechanism being in an extended state according to the first example not according to the present invention;
FIG. 8 is a diagram showing a slide rail mechanism with an unlocking handle being located at a first position according to an embodiment of the present invention;
FIG. 9 is a diagram showing the slide rail mechanism with the unlocking handle being located at a second position according to the an embodiment of the present invention; and
FIG. 10 is a diagram showing slide rail assemblies of a slide rail mechanism being in a retracted state according to a second example not according to the present invention.

### Detailed Description

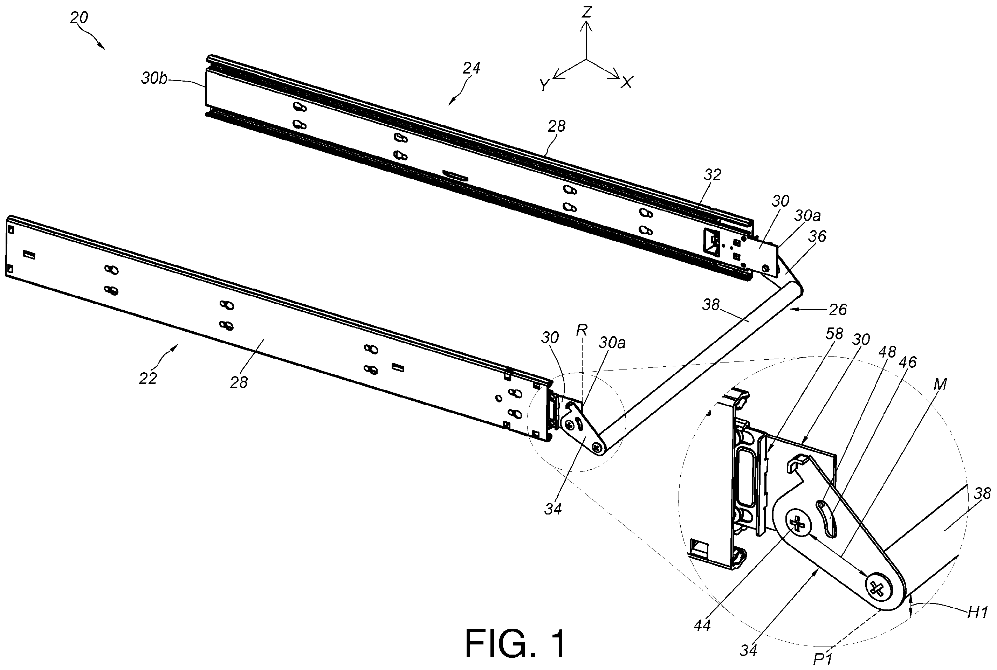

As shown in FIG. 1, FIG. 2 and FIG. 3, a slide rail mechanism 20 comprises a first slide rail assembly 22, a second slide rail assembly 24 and an unlocking handle 26 according to a first example not according to the present invention. The first slide rail assembly 22 and the second slide rail assembly 24 have substantially identical structural configuration. Each of the slide rail assemblies 22, 24 comprises a first rail 28 and a second rail 30. The first rail 28 and the second rail 30 are longitudinally movable relative to each other, and the second rail 30 can be located relative to the first rail 28 at a predetermined position R (such as a retracted position, but the present example is not limited thereto). In the present example not according to the invention, the X-axis is a longitudinal direction (or a length direction of the slide rail), the Y-axis is a transverse direction (or a lateral direction of the slide rail), and the Z-axis is a vertical direction (or a height direction of the slide rail).

Preferably, the first rail 28 is configured to be fixed to a rack or a cabinet (not shown in figures), and the second rail 30 is configured to carry a carried object (not shown in figures).

Preferably, each of the slide rail assemblies 22, 24 further comprises a third rail 32 movably mounted between the first rail 28 and the second rail 30 and configured to extend an opening traveling distance of the second rail 30 relative to the first rail 28.

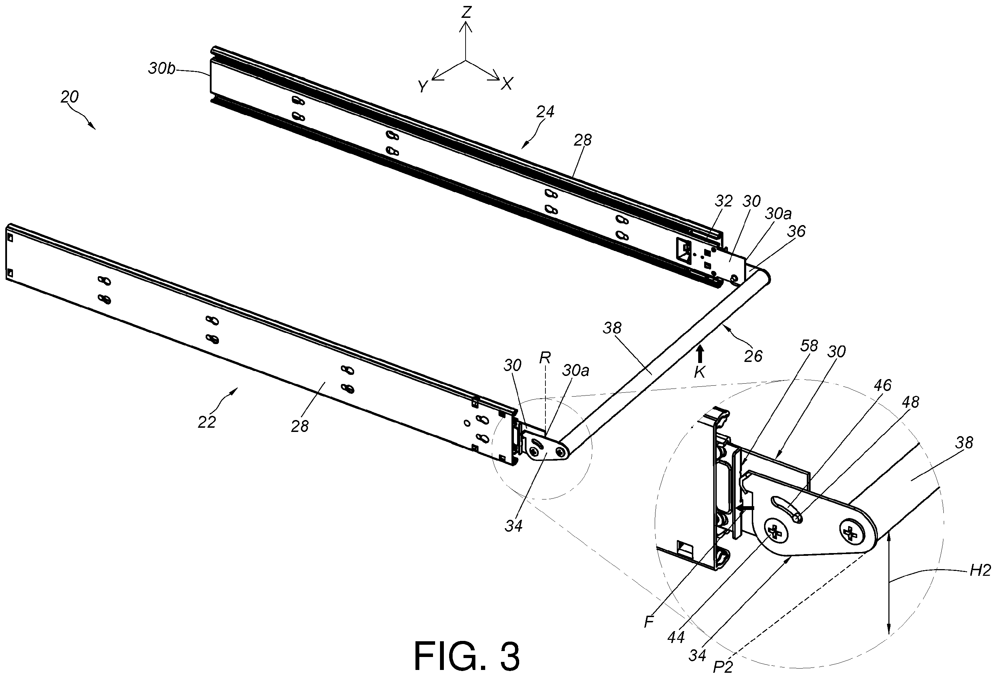

The unlocking handle 26 is movably mounted between the first slide rail assembly 22 and the second slide rail assembly 24. For example, the unlocking handle 26 is movable from a first position P1 (as shown in FIG. 1) to a second position P2 (as shown in FIG. 3). In the present example not according to the invention, the unlocking handle 26 is movably mounted between the second rail 30 of the first slide rail assembly 22 and the second rail 30 of the second slide rail assembly 24, such that the unlocking handle 26 is movable relative to the second rail 30 of the first slide rail assembly 22 and the second rail 30 of the second slide rail assembly 24.

Preferably, each of the second rails 30 has a front part 30a and a rear part 30b, and the unlocking handle 26 is arranged adjacent to the front parts 30a of the two second rails 30.

Preferably, the unlocking handle 26 comprises two working members (such as a first working member 34 and a second working member 36) and a linkage rod 38**.** The two working members 34, 36 have substantially identical structural configuration. The linkage rod 38 is arranged between the two working members 34, 36. The two working members 34, 36 are rotatably connected to the second rail 30 of the first slide rail assembly 22 and the second rail 30 of the second slide rail assembly 24 respectively. For example, a user can apply a force K along a predetermined direction (such as an upward direction) to the linkage rod 38 of the unlocking handle 26, such that the two working members 34, 36 of the unlocking handle 26 are rotated to move from the first position P1 (as shown in FIG. 1) to the second position P2 (as shown in FIG 3).

Preferably, when the unlocking handle 26 is located at the first position P1, the linkage rod 38 of the unlocking handle 26 is at a first height H1 relative to each of the slide rail assemblies 22, 24 (as shown in FIG 1). When the unlocking handle 26 is located at the second position P2, the linkage rod 38 of the unlocking handle 26 is at a second height H2 relative to each of the slide rail assemblies 22, 24 (as shown in FIG 3). The second height H2 is different from the first height H1. For example, the second height H2 is higher than the first height H1. In other words, when the unlocking handle 26 is operated, the linkage rod 38 of the unlocking handle 26 is moved to be at different heights relative to each of the slide rail assemblies 22, 24**.**

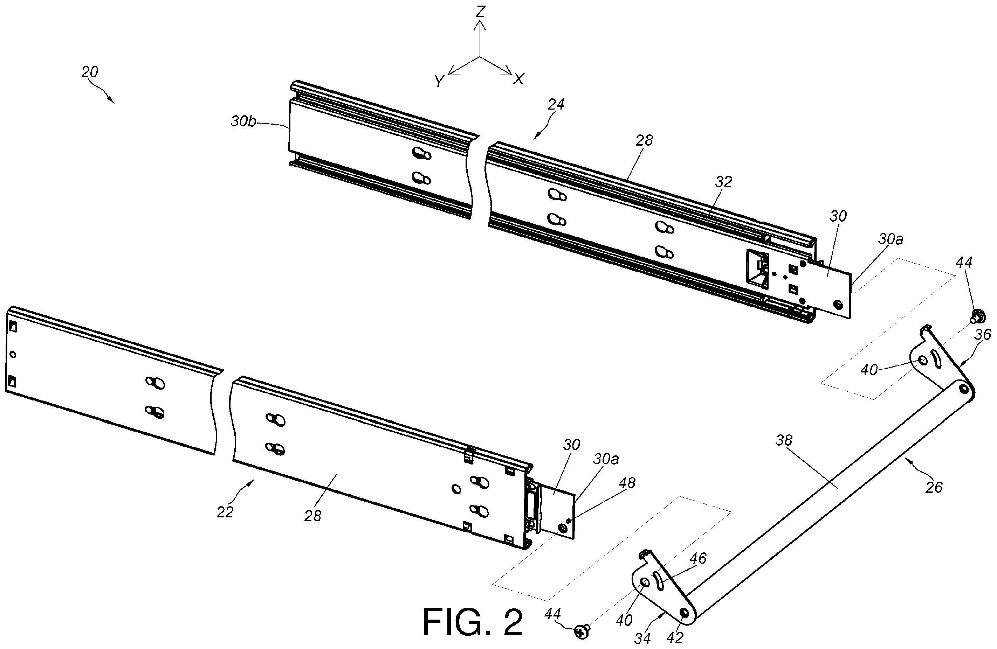

Preferably, each of the working members 34, 36 (such as the first working member 34) comprises a first part 40 and a second part 42 (as shown in FIG. 2). A predetermined distance M is defined between the first part 40 and the second part 42 (as shown in FIG. 1). The first part 40 is pivotally connected to the second rail 30 through a connecting member 44**.** The linkage rod 38 is connected to the second part 42**.**

Preferably, the unlocking handle 26 is detachably connected between the second rail 30 of the first slide rail assembly 22 and the second rail 30 of the second slide rail assembly 24. For example, the connecting member 44 can be a screw, a bolt or the like, but the present example is not limited thereto. In other words, the unlocking handle 26 can be detachably connected between the second rail 30 of the first slide rail assembly 22 and the second rail 30 of the second slide rail assembly 24 through the connecting member 44.

Preferably, each of the working members 34, 36 (such as the first working member 34) is arranged with a first limiting feature 46, and each of the second rails 30 (such as the second rail 30 of first slide rail assembly 22) is arranged with a second limiting feature 48. The two working members 34, 36 are configured to rotate within a limited range through interaction between the first limiting feature 46 and the second limiting feature 48. For example, one of the first limiting feature 46 and the second limiting feature 48 is an arc hole (or an arc slot), and the other one of the first limiting feature 46 and the second limiting feature 48 is a protrusion part extended into a portion of the arc hole (or the arc slot), but the present example is not limited thereto.

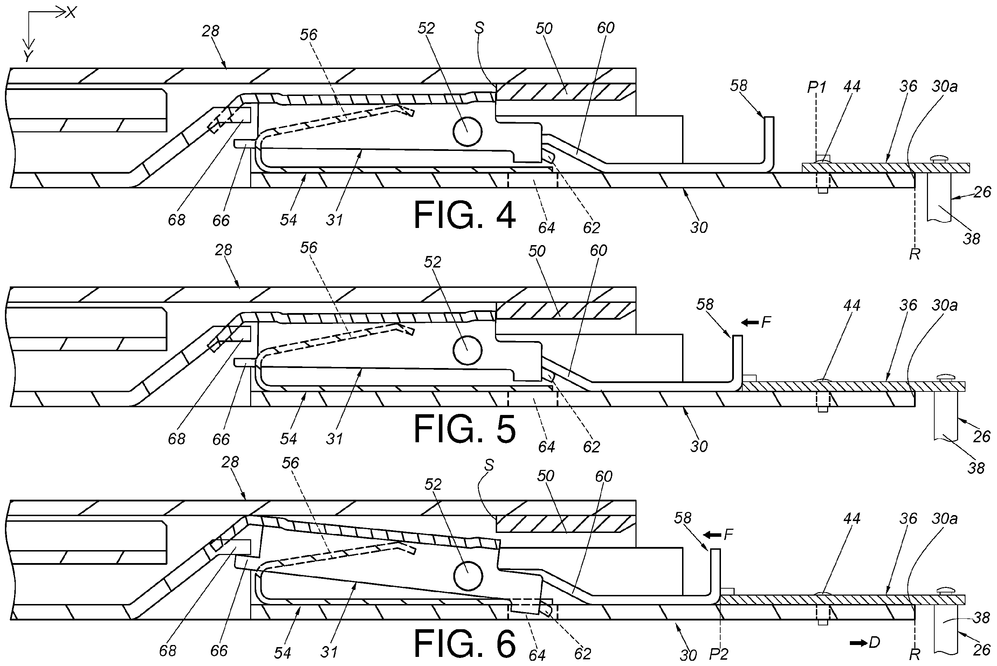

As shown in FIG. 4, each of the slide rail assemblies (the first slide rail assembly 22 and the second slide rail assembly 24) further comprises a locking member 31 configured to lock the second rail 30 relative to the first rail 28 at the predetermined position R.

Preferably, the locking member 31 is configured to block one edge S of a blocking structure 50 of the first rail 28. In the present example not according to the invention, the blocking structure 50 is a protruded structure. However, in other alternative examples, the blocking structure 50 can be a recessed (or hole) structure, but the present example is not limited thereto. Furthermore, the locking member 31 is movably mounted to the second rail 30. For example, the locking member 31 is pivotally connected to the second rail 30 through a shaft member 52.

Preferably, each of the slide rail assemblies (the first slide rail assembly 22 and the second slide rail assembly 24) further comprises an elastic member 54 attached to the second rail 30. The elastic member 54 comprises an elastic part 56 configured to provide an elastic force to the locking member 31, such that the locking member 31 can be held in a state of blocking the blocking structure 50 of the first rail 28.

Preferably, each of the slide rail assemblies 22, 24 further comprises an operating member 58 movably mounted to the second rail 30. For example, the operating member 58 is linearly movable relative to the second rail 30. A linearly moving direction of the operating member 58 is identical to a moving direction (such as a longitudinal direction) of the second rail 30.

As shown in FIG 4, FIG. 5 and FIG. 6, when the unlocking handle 26 is moved from the first position P1 (as shown in FIG. 4) to the second position P2 (as shown in FIG. 6), the unlocking handle 26 is configured to drive the locking member 31 to move in order to unlock the second rail 30 relative to the first rail 28 at the predetermined location R (as shown in FIG. 6), such that the second rail 30 can be moved away from the predetermined location R.

Furthermore, when the user applies the force K to the unlocking handle 26, each of the working members 34, 36 (such as the second working member 36) of the unlocking handle 26 is rotated and moved from the first position P1 (as shown in FIG. 4) to the second position P2 (as shown in FIG. 6) by the force K, such that each of the working members 34, 36 (such as the second working member 36) is configured to drive the locking member 31 to move through the operating member 58 in order to unlock the second rail 30 relative to the first rail 28 at the predetermined location R. For example, when the user applies the force K to the linkage rod 38 of the unlocking handle 26, the two working members 34, 36 of the unlocking handle 26 are rotated around the connecting member 44 as a rotational axis to be moved from the first position P1 (as shown in FIG. 4 and FIG. 1) to the second position P2 (as shown in FIG. 6 and FIG. 3), such that each of the two working members 34, 36 generates a driving force F to drive the operating member 58 to move linearly. A first feature 60 of the operating member 58 is configured to be in contact with a second feature 62 of the locking member 31 (such as a contact between two inclined portions as shown in FIG. 5, or a contact between an inclined portion and an arc portion, or a contact between two arc portions), such that the operating member 58 can easily drive the locking member 31 to deflect an angle, in order to disengage the locking member 31 from the edge S of the blocking structure 50 of the first rail 28 (as shown in FIG. 6 ), so as to allow the second rail 30 to move relative to the first rail 28 along a direction D (such as an opening direction). When the locking member 31 is operated to deflect the angle, the elastic part 56 of the elastic member 54 is elastically bent to be in a state of accumulating an elastic force (as shown in FIG. 6 ), and the second feature 62 of the locking member 31 is moved toward a hole 64 of the second rail 30. Moreover, when the locking member 31 is driven to deflect the angle, a shoulder part 66 of the locking member 31 is configured to abut against a limiting part 68 of the second rail 24 (as shown in FIG. 6).

Moreover, in other alternative examples, the operating member 58 can be omitted. Furthermore, when the unlocking handle 26 is operated to move from the first position P1 to the second position P2, each of the working members 34, 36 (such as the second working member 36) can directly drive the locking member 31 to move in order to unlock the second rail 30 relative to the first rail 28 at the predetermined position **R.**

Therefore, the user only needs to apply the force K to the linkage rod 38 of the unlocking handle 26 with one hand, such that the unlocking handle 26 can be moved from the first position P1 to the second position P2 in order to unlock the second rails 30 relative to the first rails 28 of the two opposite slide rail assemblies 22, 24 at the predetermined position R. It is convenient to the user since there is no need to operate with both hands. In addition, the predetermined distance M of each of the working members 34, 36 (such as the first working member 34) can be regarded as a length of a moment arm, such that a labor-saving effect can be achieved when the user applies the force K to the linkage rod 38 of the unlocking handle 26 to drive the locking member 31 to move.

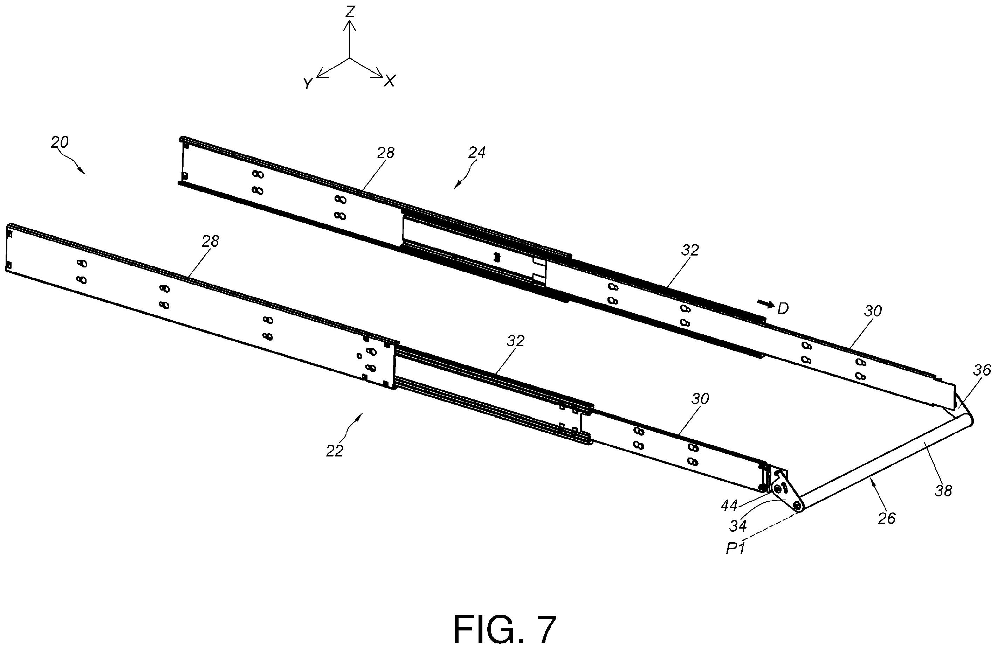

As shown in FIG. 7, when the locking member 31 is disengaged from the blocking structure 50 of the first rail 28, the second rail 30 can be moved away from the predetermined position R relative to the first rail 28, such that both the second rail 30 and the third rail 32 are movable relative to the first rail 28 along the direction D to make each of the slide rail assemblies 22, 24 in an extended state. When the user stops applying the force K to the linkage rod 38 of the unlocking handle 26, the two working members 34, 36 of the unlocking handle 26 return to the first position P1 (as shown in Figure 7) from the second position P2 (please refer to FIG. 3).

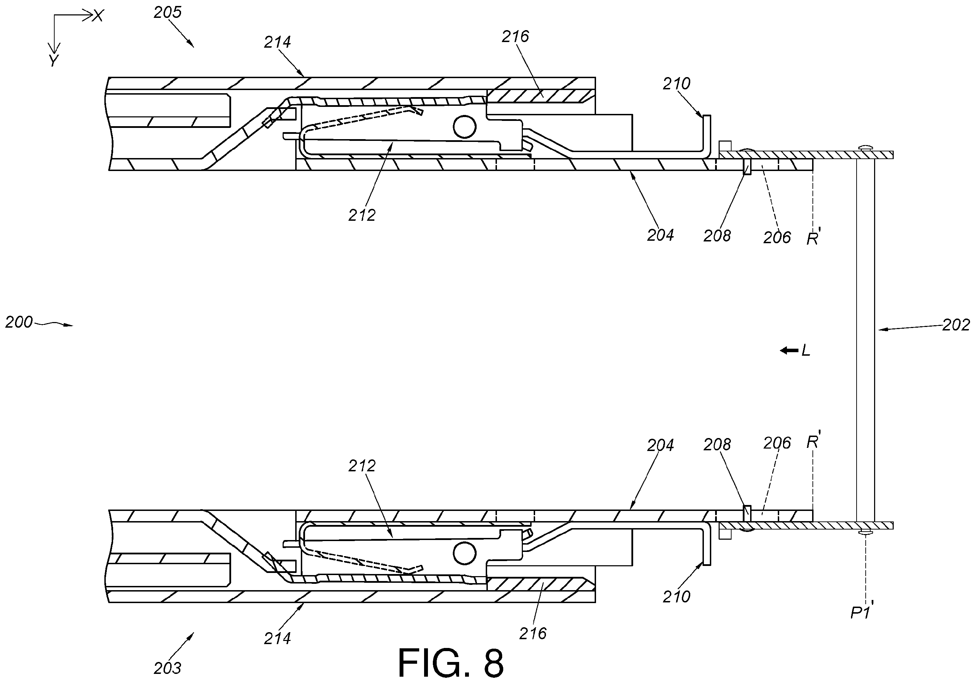

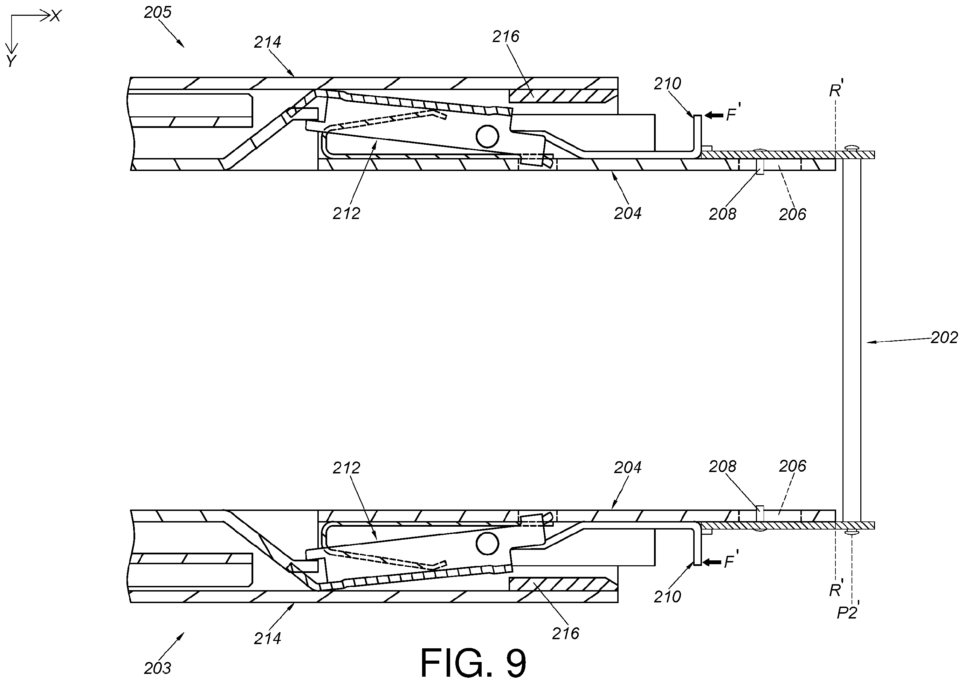

FIG. 8 and FIG. 9 are diagrams showing a slide rail mechanism 200 according to an embodiment of the present invention. In the first example not according to the invention, the unlocking handle 26 of the slide rail mechanism 20 is moved through rotation of the working member 34. A main difference between the embodiment of the invention and the first example not according to the invention is that an unlocking handle 202 of the slide rail mechanism 200 of the embodiment is linearly (or longitudinally) moved from a first position P1' (as shown in FIG. 8) to a second position P2' (as shown in FIG. 9).

Furthermore, one of a second rail 204 and the unlocking handle 202 of each of the slide rail assemblies (a first slide rail assembly 203 and a second slide rail assembly 205) comprises a first predetermined feature 206 (such as a longitudinal groove or a longitudinal hole), and the other one of the second rail 204 and the unlocking handle 202 comprises a second predetermined feature 208 (such as a protrusion or an object similar to the connecting member 44, which can be inserted into a portion of the longitudinal slot or longitudinal hole). Through interaction between the first predetermined feature 206 and the second predetermined feature 208, the unlocking handle 202 can be linearly moved from the first position P1' (as shown in FIG. 8) to the second position P2' (as shown in FIG. 9) along a linear direction L, so as to provide a driving force F' to drive the operating member 210 to move the locking member 212, in order to disengage the locking member 212 from a blocking structure 216 of the first rail 214 (as shown in FIG. 9), thus the second rail 204 can be moved away from the predetermined position R' relative to the first rail 214. The linear direction L is identical to a moving direction of the second rail 204. For example, both of the linear direction L and the moving direction of the second rail 204 are longitudinal directions. In other words, the linear direction L is substantially parallel to the moving direction of the second rail 204. Moreover, configuration of the locking member 212 locking the second rail 204 relative to the first rail 214 of the embodiment of the invention dd is identical to that of the first example not according to the invention. For simplification, no further illustration is provided.

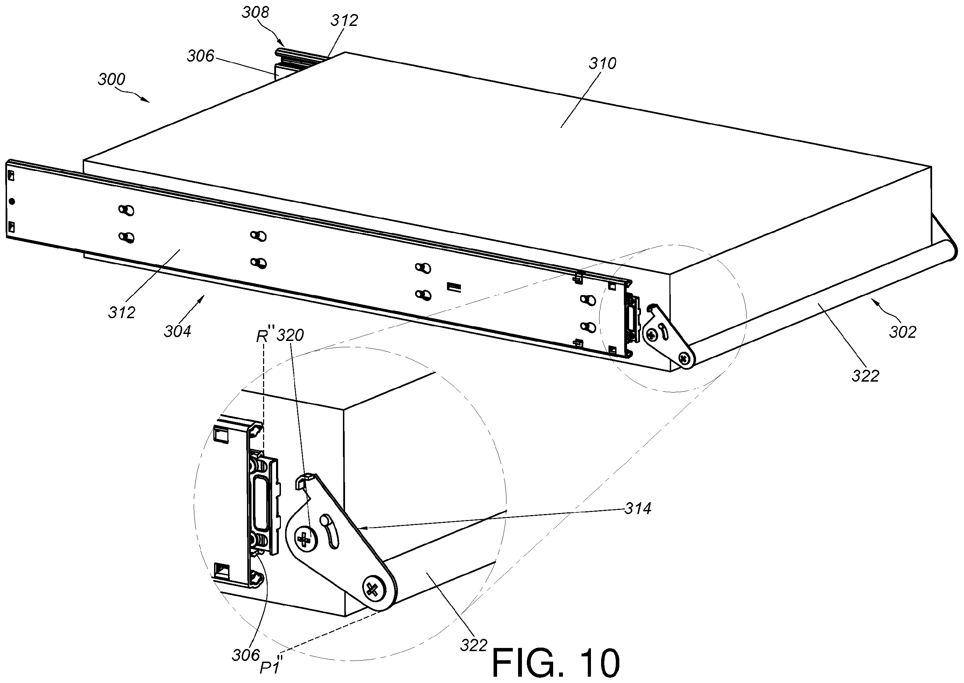

FIG. 10 is a diagram showing a slide rail mechanism 300 according to a second example not according to the present invention. In the first embodiment, the unlocking handle 26 of the slide rail mechanism 20 is movably mounted between the second rail 30 of the first slide rail assembly 22 and the second rail 30 of the second slide rail assembly 24. A main difference between the second and the first example is that an unlocking handle 302 of the slide rail mechanism 300 of the second example not according to the invention is movably mounted to a carried object 310 mounted between a second rail 306 of the first slide rail assembly 304 and a second rail 306 of the second slide rail assembly 308.

Furthermore, the first rail 312 of each of the slide rail assemblies 304, 308 can be fixed to a rack or a cabinet (not shown in figures), and the second rail 306 of each of the slide rail assemblies 304, 308 is configured to carry the carried object 310. Each of working members 314 comprises a first part and a second part. The first part is pivotally connected to the carried object 310 through a connecting member 320. The connecting member 320 can be a screw, a bolt or the like, but the present example is not limited thereto. A linkage rod 322 is connected to the second parts of the working members 314.

According to such configuration, the user can also apply a force to drive the unlocking handle 302 to move (for example, rotate or pivot) from a first position P1" to a second position P2" in order to unlock the second rails 306 relative to the first rails 312 of the two opposite slide rail assemblies 304, 308 at a predetermined position R".

In addition to the unlocking handle 202 of the slide rail mechanism 200 of the embodiment according to the present invention being mounted to a slide rail in a linearly movable manner, it is also feasible to mount the unlocking handle to a carried object mounted between the second rail of the first slide rail assembly and the second rail of the second slide rail assembly in a linearly movable manner. According to such configuration, when the unlocking handle is linearly moved from the first position to the second position relative to the second rail (or the carried object), the locking member can be driven to move in order to unlock the second rail relative to the first rail at the predetermined position.

Therefore, the slide rail mechanism and the slide rail assemblies thereof according to the embodiments of the present invention have the following technical features:
1. The unlocking handle 26 (202) can be mounted to the slide rail; or the unlocking handle 302 can be mounted to the carried object 310.
2. The user only needs to apply the force to the unlocking handle 26, 202, 302 with one hand, such that the unlocking handle 26, 202, 302 can be moved from the first position to the second position in order to unlock the second rails relative to the first rails of the two opposite slide rail assemblies at the predetermined position R. It is convenient to the user since there is no need to operate with both hands.
3. The predetermined distance M of each of the working members (such as the first working member 34) can be regarded as a length of a moment arm, such that a labor-saving effect can be achieved when the user applies the force K to the linkage rod 38 of the unlocking handle 26 to drive the locking member 31 to move.
4. The unlocking handle 26, 202 can be detachably connected between the second rail 30, 204 of the first slide rail assembly 22, 203 and the second rail 30, 204 of the second slide rail assembly 24, 205 (or the unlocking handle 302 is detachably mounted to the carried object 310 mounted between the second rail 306 of the first slide rail assembly 304 and the second rail 306 of the second slide rail assembly 308). In other words, the user can install the unlocking handle 26, 202, 302 according to requirements.
5. When the second rail 30, 204, 306 is unlocked relative to the first rail 28, 214, 312 at the predetermined position, the user can easily move the second rail 30 , 204, 306 (or the carried object 310) away from the predetermined position (such as the retracted position) by pulling the unlocking handle 26, 202, 302.

## Claims

1. A slide rail mechanism (200), comprising:
a first slide rail assembly (203) and a second slide rail assembly (205), each of the first and second slide rail assemblies (203) (205) comprising a first rail (214) and a second rail (204) movable relative to each other, and a locking member (212) configured to lock the second rail (204) relative to the first rail (214) at a predetermined position (R'); and a blocking structure (216) of the first rail (214); and
an unlocking handle (202) movably mounted between the first slide rail assembly (203) and the second slide rail assembly (205);
wherein when the unlocking handle (202) is moved from a first position (P1') to a second position (P2'), the unlocking handle (202) is configured to drive the locking member (212) to move in order to unlock the second rail (204) relative to the first rail (214) at the predetermined position (R');
wherein the unlocking handle (202) is configured to be linearly moved from the first position (P1') to the second position (P2');
wherein one of the second rail (204) and the unlocking handle (202) of each of the first slide rail assembly (203) and the second slide rail assembly (205) comprises a first predetermined feature (206), and the other one of the second rail (204) and the unlocking handle (202) comprises a second predetermined feature (208), wherein , through interaction between the first predetermined feature (206) and the second predetermined feature (208), the unlocking handle (202) is linearly moved from the first position (P1') to the second position (P2') along a linear direction (L) so as to provide a driving force (F') to drive the operating member (210) to move the locking member (212), in order to disengage the locking member (212) from the blocking structure (216) of the first rail (214);
wherein the linear direction (L) is identical to a moving direction of the second rail (204).

2. The slide rail mechanism of claim 1, **characterized in that** the unlocking handle (202) is movably mounted between the second rail (204) of the first slide rail assembly (203) and the second rail (204) of the second slide rail assembly (205).

3. The slide rail mechanism of claim 2, **characterized in that** the unlocking handle (202) is movably mounted on a carried object (310) mounted between the second rail (204) of the first slide rail assembly (203) and the second rail (304) of the second slide rail assembly (205).

4. The slide rail mechanism of claim 2, **characterized in that** the unlocking handle (202) is detachably connected between the second rail (204) of the first slide rail assembly (203) and the second rail (204) of the second slide rail assembly (205).

5. The slide rail mechanism of any of claims 1 to 4, wherein:
the first predetermined feature (206) is a longitudinal groove or a longitudinal hole; and
the second predetermined feature (208) is a protrusion or a connecting member, which can be inserted into a portion of the longitudinal slot or longitudinal hole.

6. The slide rail mechanism of any of claims 1 to 5, wherein each of the first slide rail assembly (203) and the second slide rail assembly (205) further comprises the operating member (210) movably mounted to the second rail (204).

## Patentansprüche

1. Gleitschienenmechanismus (200), aufweisend:
eine erste Gleitschienenanordnung (203) und eine zweite Gleitschienenanordnung (205), wobei jede der ersten und der zweiten Gleitschienenanordnung (203) (205) aufweist: eine erste Schiene (214) und eine zweite Schiene (204), die relativ zueinander bewegbar sind, und ein Verriegelungselement (212), das konfiguriert ist, um die zweite Schiene (204) relativ zu der ersten Schiene (214) in einer vorbestimmten Position (R') zu verriegeln, und eine Blockierstruktur (216) der ersten Schiene (214), und
einen Entriegelungsgriff (202), der bewegbar zwischen der ersten Gleitschienenanordnung (203) und der zweiten Gleitschienenanordnung (205) montiert ist,
wobei, wenn der Entriegelungsgriff (202) von einer ersten Position (R1') in eine zweite Position (P2') bewegt wird, der Entriegelungsgriff (202) konfiguriert ist, um das Verriegelungselement (212) anzutreiben, um sich zu bewegen, um die zweite Schiene (204) relativ zur ersten Schiene (214) an der vorbestimmten Position (R') zu entriegeln,
wobei der Entriegelungsgriff (202) konfiguriert ist, um linear von der ersten Position (R1') in die zweite Position (P2') bewegt zu werden,
wobei eines von der zweiten Schiene (204) und dem Entriegelungsgriff (202) von jeder der ersten Gleitschienenanordnung (203) und der zweiten Gleitschienenanordnung (205) ein erstes vorbestimmtes Merkmal (206) aufweist, und das andere von der zweiten Schiene (204) und dem Entriegelungsgriff (202) ein zweites vorbestimmtes Merkmal (208) aufweist, wobei durch Wechselwirkung zwischen dem ersten vorbestimmten Merkmal (206) und dem zweiten vorbestimmten Merkmal (208) der Entriegelungsgriff (202) linear aus der ersten Position (P1') in die zweite Position (P2') entlang einer linearen Richtung (L) bewegt wird, um eine Antriebskraft (F') zum Antreiben des Betätigungselements (210) zum Bewegen des Verriegelungselements (212) bereitzustellen, um das Verriegelungselement (212) aus der Blockierstruktur (216) der ersten Schiene (214) zu lösen, wobei die lineare Richtung (L) identisch mit einer Bewegungsrichtung der zweiten Schiene (204) ist.

2. Gleitschienenmechanismus gemäß Anspruch 1, **dadurch gekennzeichnet, dass** der Entriegelungsgriff (202) bewegbar zwischen der zweiten Schiene (204) der ersten Gleitschienenanordnung (203) und der zweiten Schiene (204) der zweiten Gleitschienenanordnung (205) montiert ist.

3. Gleitschienenmechanismus gemäß Anspruch 2, **dadurch gekennzeichnet, dass** der Entriegelungsgriff (202) bewegbar an einem getragenen Objekt (310) montiert ist, das zwischen der zweiten Schiene (204) der ersten Gleitschienenanordnung (203) und der zweiten Schiene (304) der zweiten Gleitschienenanordnung (205) montiert ist.

4. Gleitschienenmechanismus gemäß Anspruch 2, **dadurch gekennzeichnet, dass** der Entriegelungsgriff (202) zwischen der zweiten Schiene (204) der ersten Gleitschienenanordnung (203) und der zweiten Schiene (204) der zweiten Gleitschienenanordnung (205) lösbar verbunden ist.

5. Gleitschienenmechanismus gemäß irgendeinem der Ansprüche 1 bis 4, wobei:
das erste vorbestimmte Merkmal (206) eine Längsnut oder ein Längsloch ist, und
das zweite vorbestimmte Merkmal (208) ein Vorsprung oder ein Verbindungselement ist, das in einen Abschnitt des Längsschlitzes oder des Längslochs eingesetzt sein kann.

6. Gleitschienenmechanismus gemäß irgendeinem der Ansprüche 1 bis 5, wobei jede von der ersten Gleitschienenanordnung (203) und der zweiten Gleitschienenanordnung (205) ferner das Betätigungselement (210) aufweist, das bewegbar an der zweiten Schiene (204) montiert ist.

## Revendications

1. Mécanisme à glissière (200), comprenant :
un premier ensemble de glissière (203) et un deuxième ensemble de glissière (205), chacun des premier et deuxième ensembles de glissière (203) (205) comprenant un premier rail (214) et un deuxième rail (204) mobiles l'un par rapport à l'autre, et un élément de verrouillage (212) configuré pour verrouiller le deuxième rail (204) par rapport au premier rail (214) dans une position prédéterminée (R') ; et une structure de blocage (216) du premier rail (214) ; et
une poignée de déverrouillage (202) montée de manière mobile entre le premier ensemble de glissière (203) et le deuxième ensemble de glissière (205) ;
dans lequel, lorsque la poignée de déverrouillage (202) est déplacée d'une première position (R1') à une deuxième position (P2'), la poignée de déverrouillage (202) est configurée pour entraîner l'élément de verrouillage (212) à se déplacer afin de déverrouiller le deuxième rail (204) par rapport au premier rail (214) à la position prédéterminée (R') ;
dans lequel la poignée de déverrouillage (202) est configurée pour être déplacée linéairement de la première position (R1') à la deuxième position (P2') ;
dans lequel l'un du deuxième rail (204) et de la poignée de déverrouillage (202) de chacun des premier ensemble de glissière (203) et deuxième ensemble de glissière (205) comprend une première caractéristique prédéterminée (206), et l'autre parmi le deuxième rail (204) et la poignée de déverrouillage (202) comprend une deuxième caractéristique prédéterminée (208), dans lequel, grâce à une interaction entre la première caractéristique prédéterminée (206) et la deuxième caractéristique prédéterminée (208), la poignée de déverrouillage (202) est déplacée linéairement de la première position (P1') à la deuxième position (P2') le long d'une direction linéaire (L) de manière à fournir une force d'entraînement (F') pour entraîner l'élément d'actionnement (210) afin de déplacer l'élément de verrouillage (212), afin de mettre hors prise l'élément de verrouillage (212) de la structure de blocage (216) du premier rail (214) ;
dans lequel la direction linéaire (L) est identique à une direction de déplacement du deuxième rail (204).

2. Mécanisme à glissière selon la revendication 1, **caractérisé en ce que** la poignée de déverrouillage (202) est montée de manière mobile entre le deuxième rail (204) du premier ensemble de glissière (203) et le deuxième rail (204) du deuxième ensemble de glissière (205).

3. Mécanisme à glissière selon la revendication 2, **caractérisé en ce que** la poignée de déverrouillage (202) est montée de manière mobile sur un objet transporté (310) monté entre le deuxième rail (204) du premier ensemble de glissière (203) et le deuxième rail (304) du deuxième ensemble de glissière (205).

4. Mécanisme à glissière selon la revendication 2, **caractérisé en ce que** la poignée de déverrouillage (202) est reliée de manière amovible entre le deuxième rail (204) du premier ensemble de glissière (203) et le deuxième rail (204) du deuxième ensemble de glissière (205).

5. Mécanisme à glissière selon l'une quelconque des revendications 1 à 4, dans lequel :
la première caractéristique prédéterminée (206) est une rainure longitudinale ou un trou longitudinal ; et
la deuxième caractéristique prédéterminée (208) est une saillie ou un élément de connexion, qui peut être inséré dans une partie de la fente longitudinale ou du trou longitudinal.

6. Mécanisme à glissière selon l'une quelconque des revendications 1 à 5, dans lequel chacun des premier ensemble de glissière (203) et deuxième ensemble de glissière (205) comprend en outre l'élément d'actionnement (210) monté de manière mobile sur le deuxième rail (204).
